# EUROPEAN PATENT SPECIFICATION

(11) **EP 3 150 992 B1**
(45) Date of publication and mention of the grant of the patent: **27.05.2020**
(21) Application number: 15798968.2
(22) Date of filing: 27.05.2015
(51) Int. Cl.: G01N 21/62, H01J 37/06, H01J 37/244, H01J 37/252, G01N 23/2251

(54) **INVERSE PHOTOELECTRON SPECTROSCOPY DEVICE**
INVERSE FOTOELEKTRONENSPEKTROSKOPIEVORRICHTUNG
DISPOSITIF DE SPECTROSCOPIE PHOTOÉLECTRONIQUE INVERSE

(30) Priority: 29.05.2014 JP 2014111515
(43) Date of publication of application: 05.04.2017
(73) Proprietor: Japan Science and Technology Agency, Kawaguchi-shi, Saitama 332-0012 (JP)
(72) Inventor: YOSHIDA, Hiroyuki, Chiba-shi, Chiba 263-8522 (JP)
(74) Representative: Prinz & Partner mbB
(86) International application number: PCT/JP2015/065197
(87) International publication number: WO 2015/182641

(56) References cited:
- WO-A1-2013/129390
- JP-A- H07 260 717
- JP-A- H07 260 718
- HIDEAKI NAKANE: 'THERMAL FIELD EMITTER USING YTTRIUM OXIDE' IEICE TECHNICAL REPORT vol. 103, no. 497, 05 December 2003, pages 21 - 25, XP008184119
- DATABASE INSPEC [Online] THE INSTITUTION OF ELECTRICAL ENGINEERS, STEVENAGE, GB; December 1973 (1973-12), KOITABASHI M: "Thermionic properties of press-sintered yttrium oxide-tungsten cathodes", Database accession no. 660273 & MITSUBISHI DENKI LABORATORY REPORTS JAPAN, vol. 14, no. 1-4, 1973, pages 53-74, ISSN: 0026-6795
- "266. A vapour-jet vacuum pump - V E Minaichev et al, USSR Patent, No 259,317, appl 3rd Aug 1968, publd 23rd Apr 1970", VACUUM, PERGAMON PRESS, GB, vol. 21, no. 5, 1 May 1971 (1971-05-01), page 190, XP024692688, ISSN: 0042-207X, DOI: 10.1016/0042-207X(71)91911-7 [retrieved on 1971-05-01]

## Description

### FIELD OF THE INVENTION

The present invention relates to an inverse photoemission spectroscopy apparatus for detecting light generated by the relaxation of electrons to an unoccupied state of a sample when the sample, e.g. an organic semiconductor is irradiated by an electron beam.

### BACKGROUND OF THE INVENTION

Currently, vigorous research has been conducted on devices using an organic semiconductor, such as an organic thin film transistor (OTFT) and an organic thin film solar cell. To develop an organic semiconductor device, it may be necessary to accurately measure a valence level and an unoccupied electronic state or a conduction level (or electron affinities serving as the minimum energy, density of states, etc.). A valence level or a valence band can be measured by photoelectron spectroscopy where energy of electrons emitted when a sample is irradiated with light is measured. A known method for measuring an unoccupied electronic state or a conduction band is Inverse Photoemission Spectroscopy (IPES).

In inverse photoemission spectroscopy, a sample is irradiated with an electron beam having homogenous energy, and then a spectrum of light, which is generated when electrons in the sample relax to an unoccupied state, is measured as a function of electron energy to evaluate electron affinities.

Conventionally, in inverse photoemission spectroscopy, in order to obtain a large signal intensity, a sample is irradiated with a strong electron beam to detect vacuum ultraviolet light generated therein. In this case, however, the following problems have occurred. A first problem is that when an organic semiconductor is used as a sample, the sample is easily damaged or altered by the electron beam. A second problem is that vacuum ultraviolet light is required to be detected in a high vacuum state because vacuum ultraviolet light is to be absorbed by oxygen. This problem makes the device structure complicated. A third problem is that the detection of vacuum ultraviolet light requires a special optical system with low resolution, etc.

In view of the above problems, in low-energy inverse photoemission spectroscopy (LEIPS) disclosed in Patent Document 1 and Non-Patent Documents 1 to 4, a sample is irradiated with an ultra-low-speed electron beam having energy lower than the covalent bond energy of molecules of the sample to prevent the sample from being damaged. It is an additional advantage that the light emitted from the sample is near-ultraviolet light, which is not absorbed by oxygen. Thus, detection of the light can be performed in the air. It is also an additional advantage that commercial silica glass, a multilayer interference bandpass filter, etc., which were not available for detecting vacuum ultraviolet light, can be used to detect light with high sensitivity, so that high resolution is achieved.

### PRIOR ART DOCUMENTS

### PATENT DOCUMENT

Patent Document 1: WO 2013/129390 A

### NON-PATENT DOCUMENTS

Non-Patent Document 1: Hiroyuki Yoshida, "Near-ultraviolet inverse photoemission spectroscopy using ultra-low energy electrons", Chem. Phys. Lett. 539-540, 180-185 (2012)
Non-Patent Document 2: Hiroyuki Yoshida, "Measuring the electron affinity of organic solids: An indispensable new tool for organic electronics", Anal. Bioanal. Chem. (Trend2014) 406:2231-2237
Non-Patent Document 3: Hiroyuki Yoshida, "Low energy inverse photoemission spectroscopy apparatus", Rev. Sci. Instrum. 85, 016101 (2014)
Non-Patent Document 4: Hiroyuki Yoshida, "Low-energy inverse photoemission spectroscopy using a high-resolution grating spectrometer in the near ultraviolet range", Rev. Sci. Instrum. 84, 103901 (2013)

### SUMMARY OF THE INVENTION

In Patent Document 1 and Non-Patent Documents 1 to 4, barium oxide BaO is used as the thermionic emission material of the cathode because the operation temperature thereof is low.

Hideaki Nakane: "Thermal field emitter using Yttrium oxide", IEICE Technical Report, vol. 103, No. 497, 5 December 2003 (2003-12-05), pages 21 to 25, XP008184119, discloses a thermal field emitter using Yttrium oxide and mentions that Yttrium oxide has a lower work function than ZrO.

The Institution of Electrical Engineers, Stevenage, GB; December 1973; Koitabashi M: "Thermionic properties of press-sintered yttrium oxide-tungsten cathodes" mentions various characteristics of sintered yttrium oxide as a cathode. For example, for a cathode of 50% Y2O3, the critical poisoning pressure being at 1500°C is 2·10-6 Torr.

USSR Patent No 259,317 lists advantages of yttrium oxide as a thermionic cathode in comparison with thorium oxide. Several refractory metals are discussed. Just as in D5, no examples of a use of such a cathode is given.

However, barium oxide has high reactivity due to the fact is that the work function of barium is low. Therefore, when reacting with water or air, the barium oxide will be severely deteriorated, possibly resulting in decreased electrons emitted. This makes it difficult to store or handle the barium oxide cathode. In addition to this, it is necessary to sufficiently bake out the vacuum chamber or locate the cathode in a vacuum chamber with an ultra-high vacuum in the order of 10⁻¹⁰ Torr (10⁻¹⁰ hPa). To perform the baking, a heat-resistant material is considered necessary for the user's safety. Furthermore, to achieve the ultra-high vacuum, an expensive seal (e.g., metallic gasket) and a special vacuum pump and expertise in operating such a device are required.

The present invention has been made to solve the above problems. It is an object of the present invention to provide a low-cost inverse photoemission spectroscopy apparatus which is easy to handle.

One aspect of the present invention relates to an inverse photoemission spectroscopy apparatus for detecting a light generated by the relaxation of electrons to an unoccupied state of a sample, the apparatus including:
- an electron source for generating electrons with which a sample is irradiated;
- a wavelength selector for extracting a light having a certain wavelength from the light generated in the sample;
- a photodetector for detecting the light extracted by the wavelength selector; and
- a focusing optics disposed between the sample and the photodetector, wherein the electron source contains yttrium oxide as a thermionic emission material.

In one aspect of the present invention, the photodetector may include a photoelectric converter of the solar-blind type that is insusceptible or insensitive to a light having a wavelength of 400 nm or longer.

In one aspect of the present invention, the photoelectric converter of the solar-blind type may contain a photoelectric conversion material selected from the group consisting of cesium iodide, cesium tellurium, and gallium nitride.

In one aspect of the present invention, the focusing optics may include:
- a collimating lens disposed between the sample and the wavelength selector so that the light generated in the sample is shaped into a collimated light flux; and
- an imaging lens disposed between the wavelength selector and the photodetector so that the light extracted by the wavelength selector is focused to form an image on the photoelectric converter of the photodetector.

In one aspect of the present invention, the wavelength selector may be an interference bandpass filter of a dielectric multilayer.

In one aspect of the present invention, the sample may be irradiated with an electron beam having energy of 5 eV or less, and the wavelength selector may have a transmission wavelength range between 150 nm and 700 nm.

According to one aspect of the present invention, the electron source contains, as a thermionic emission material, yttrium oxide which can maintain its performance even if it is not in an ultra-high vacuum state. Thus, a low-cost inverse photoemission spectroscopy apparatus which is easy to handle can be achieved. As a result, a valence level and an unoccupied electronic state can be accurately measured with ease, and development of devices using an organic semiconductor, for example, can be promoted.

### BRIEF DESCRIPTION OF THE DRAWINGS

Fig. 1 is a diagram schematically showing an inverse photoemission spectroscopy apparatus according to an embodiment of the present invention.
Fig. 2 is a cross-sectional view showing a main part of an electron gun.
Figs. 3(a) and 3(b) are illustrations used for explaining advantages derived from an optical system according to an embodiment of the present invention. Fig. 3(a) shows a conventional optical system and Fig. 3(b) shows the optical system according to an embodiment of the present invention.
Figs. 4(a) and 4(b) are graphs showing results obtained by the measurement of kinetic energy distribution of electrons as a function of time for a barium oxide cathode (a) and an yttrium oxide cathode (b).
Fig. 5 is a graph showing a kinetic energy distribution of electrons for the yttrium oxide cathode.
Fig. 6 is a graph showing a result obtained by the measurement of a LEIPS spectrum of a thin film of silver in the vicinity of Fermi edge for the yttrium oxide cathode.
Fig. 7 is a graph showing quantum efficiency as a function of wavelength only for a photo-multiplier.
Fig. 8 is a graph showing quantum efficiency as a function of wavelength for a combination of the photomultiplier and a bandpass filter.
Fig. 9 is a graph showing results obtained by the measurement of a LEIPS spectrum of zinc phthalocyanine for a Cs-Te photoelectric surface and a bialkali photoelectric surface.
Fig. 10 is a graph showing results obtained by the measurement of a LEIPS spectrum of a thin film of silver in the vicinity of Fermi edge by the conventional optical system and the optical system according to an embodiment of the present invention.

### DETAILED DESCRIPTION OF THE INVENTION

Referring to the drawings, an inverse photoemission spectroscopy apparatus according to an embodiment of the present invention will be described. In the drawings, the same or similar elements or components are denoted by the same reference numerals.

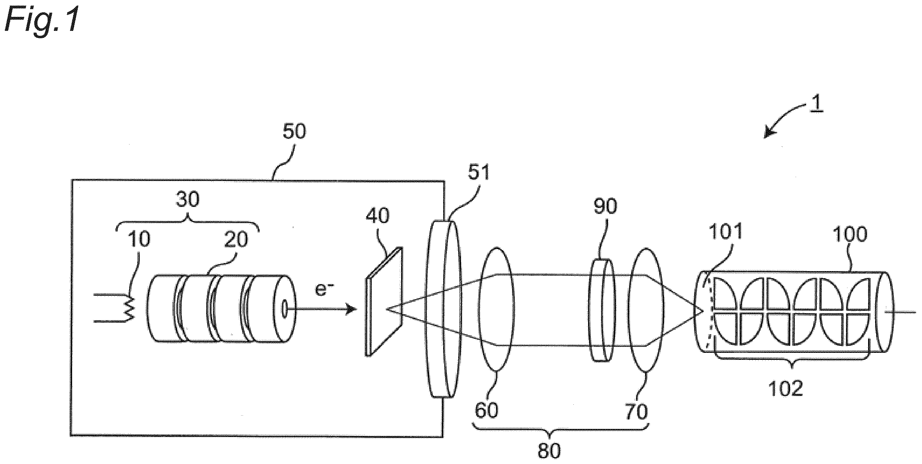

Fig. 1 is a diagram schematically showing an inverse photoemission spectroscopy apparatus 1 according to an embodiment of the present invention.

The inverse photoemission spectroscopy apparatus 1 may include an electron gun 30, condensing optics or focusing optics 80, a bandpass filter 90, a photomultiplier (or photodetector) 100. The inverse photoemission spectroscopy apparatus 1 is configured to radiate an electron beam to a sample 40 and to detect light (mainly, near-ultraviolet light) generated when electrons in the sample relax to an unoccupied state. An organic semiconductor may be assumed to be used as the sample 40. However, the sample 40 may be any other material such as semiconductor or metal. The sample 40 is provided on a board (not shown) and connected to an ammeter (e.g., pico-ampere meter).

The electron gun 30 includes a hot cathode or thermionic cathode (hereinafter, simply referred to as "cathode") 10 as an electron source or an electron generator, and an electron lens 20 for converging electrons generated in the cathode 10. The electron gun 30 irradiates the sample 40 with an electron beam, the electron beam being homogenous and having low energy, preferably less than or equal to 5 eV. The energy of the electron beam is dependent on a difference between an acceleration voltage applied to the cathode 10 by an accelerating electrode (not shown) and a bias voltage applied to the sample 40 (specifically, the acceleration voltage and the bias voltage are determined in view of work functions of the thermionic emission material and the sample 40). An energy width (a half width of kinetic energy distribution) of the electron beam emitted from the electron gun 30 is influenced by a space charge effect, in addition to an energy width of electrons generated in the cathode 10. In an embodiment of the present invention, however, the influence of the space charge effect may be ignored. Accordingly, the energy width of the electron beam emitted from the electron gun 30 is substantially the same as that of the electrons generated in the cathode 10.

The electron gun 30 and the sample 40 are disposed in a vacuum chamber 50. The vacuum chamber 50 has a window 51, preferably made of silica glass. The vacuum chamber 50 is not required to be in a so-called Ultra-High vacuum state with a pressure in the order of 10⁻¹⁰ Torr (10⁻¹⁰ hPa), but may be in a vacuum state (e.g., a pressure in the order of 10⁻⁷ Torr (10⁻⁷ hPa), preferably in the order of 10⁻⁸ Torr (10⁻⁸ hPa) in which the degree of vacuum is lower (pressure is higher) than the ultrahigh-vacuum state. It should be noted that, for example, the vacuum state with a pressure in the order of 10⁻⁷ Torr (10⁻⁷ hPa) means a state in which the degree of vacuum is higher than 1x10⁻⁶ Torr (1x10⁻⁶ hPa) and equal to or lower than 1x10⁻⁷ Torr (1x10⁻⁷ hPa).

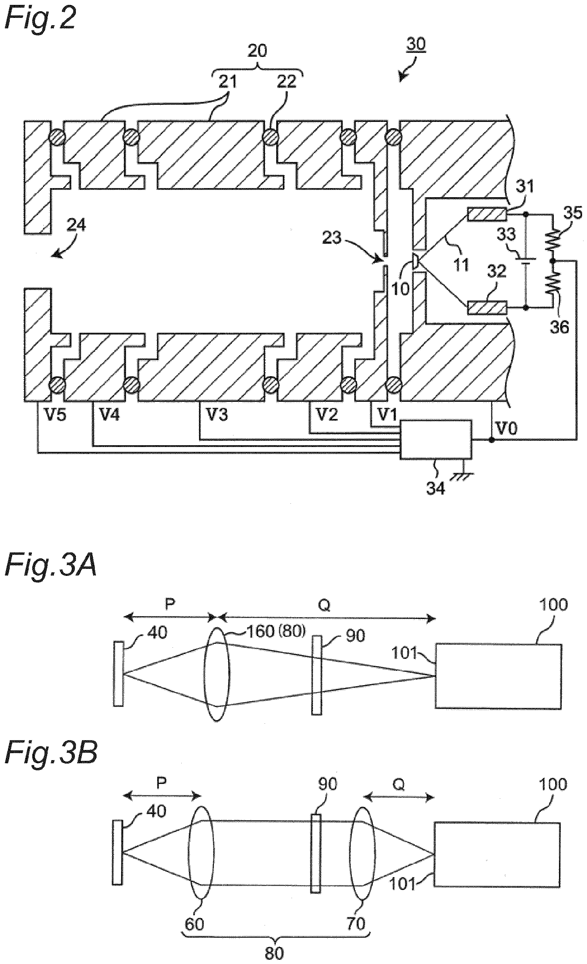

Fig. 2 is a cross-sectional view showing a main part of the electron gun 30. The cathode 10 is connected to heater electrodes 31 and 32 via a tungsten wire 11. A heater voltage is applied to the heater electrodes 31 and 32 from a heater power supply 33, and the cathode 10 heated as a result of the heater voltage emitting thermal electrons from a thermionic emission material of the cathode 10. A heater power supply 33 is connected to a controller 34, and the controller 34 is configured to control the heater voltage at, for example, a constant value.

The cathode 10 contains yttrium oxide Y₂O₃ as a thermionic emission material. The yttrium oxide, however, may have nonstoichiometric composition due to defects or impurities therein. Yttrium oxide has an ability to maintain its performance even if it is used in a state where the degree of vacuum is lower than the aforementioned ultrahigh-vacuum state. The cathode 10 includes a conductive heat-resistant base made of iridium, for example. The yttrium oxide may be applied on the heat-resistant base. The cathode 10 may have various shapes. In order to increase the emission of electrons as much as possible, even when the cathode is operated at low temperature, the cathode 10 preferably has a disk-shape.

The electron lens 20 has a plurality of electrodes 21 made of oxygen-free copper. The electrodes 21 each are connected to the controller 34. The controller 34 is also connected to the sample 40 (the connection not being shown). The controller 34 is configured to control potential differences V0 to V5 between each of the electrodes 21 and the sample 40. The plurality of electrodes 21 each have a cylindrical shape. The electrodes 21 are integrated by a long screw and a nut (not shown). Insulators 22 are embedded between the electrodes 21, 21. The insulator 22 may be a ball made of ruby or sapphire, an insulator made of ceramic, etc. If the surface of the insulator 22 is charged by an electron beam, a path of the electron beam in the electron lens 20 is to be changed. Therefore, the plurality of electrodes 21 are shaped so that the insulators 22 are hidden from the path of the electron beam.

An aperture 23 or a circular opening is formed in the electrode located closest to the cathode 10 among the plurality of electrodes 21. An aperture 24 is formed in the electrode located closest to the sample 40 among the plurality of electrodes 21.

In the electron gun 30, (1) potential differences V0 to VS between each of the electrodes 21 and the sample 40, (2) a diameter of the aperture 23, and (3) a distance between the cathode 10 and the aperture 23 are adjusted and designed. This makes it possible to control an amount of electrons (i.e., electric current) emitted from the electron gun 30 per unit time and an irradiation area by the electrons on the sample 40. In this way, current density on an irradiation surface of the sample 40 is adjusted. The current density preferably ranges from approximately 10⁻³ A/cm² to 10⁻⁸ A/cm². When the current density is larger than 10⁻³ A/cm², electrons are subject to larger Coulomb force, so that they repel from each other and spread out. When the current density is smaller than 10⁻⁸ A/cm², the detection of light from the sample 40 may become difficult. In particular, the appropriate adjustment in the aforementioned (2) and (3), electrons of necessary intensity can be extracted from the electron gun 30 with temperature of the cathode 10 during operation being decreased.

Returning to Fig. 1, the focusing optics 80 may include two lenses (convex lens) 60 and 70. The lenses 60 and 70 are made of silica glass, magnesium fluoride, lithium fluoride, etc. The lens denoted by 60 is disposed between the vacuum chamber 50 and the bandpass filter 90 so that diffused light generated in the sample 40 is shaped into a collimated light flux. Hereinafter, the lens 60 may be referred to as a collimating lens. The lens denoted by 70 is disposed between the bandpass filter 90 and the photomultiplier 100, preferably close to the bandpass filter 90 so that the collimated light flux emitted from the bandpass filter 90 is focused or condensed to form an image on a photoelectric surface 101 of the photomultiplier 100. Hereinafter, the lens 70 may be referred to as an imaging lens. Preferably, the imaging lens 70 has a focal length that is substantially the same as an effective diameter of the imaging lens 70. Although the collimating lens 60 and the imaging lens 70 are illustrated in the figures to have the same thickness, the thickness may be altered from the figures as desired.

The bandpass filter 90 may be an interference bandpass filter of a dielectric multilayer. For example, two kinds of thin films having significantly different refractive indexes, such as quartz and oxidized hafnium, are employed. About 100 layers of the above thin films are laminated alternately to constitute the bandpass filter 90. In view of a transmission wavelength range of quartz, the bandpass filter 90 preferably has a transmission wavelength range of 150 nm or longer and more preferably has a transmission wavelength range from 180 nm to 700 nm, which corresponds to electron affinities of many organic semiconductors.

The photomultiplier 100 includes a photoelectric surface 101 of a photocathode or a photoelectric converter for converting incident light into electrons, a dynode 102 (or electron multiplier) for multiplying electrons through the secondary electron emission process, and an anode (not shown) for extracting the multiplied electrons to the outside, etc. On the photoelectric surface 101, a so-called photoelectric conversion material of the solar-blind type is applied. The photoelectric conversion material of the solar-blind type that is insusceptible to light having a wavelength in a visible light range. Examples of the photoelectric conversion material may include cesium iodide Cs-I which has sensitivity to light having a wavelength ranging from 115 nm to 200 nm, cesium tellurium CsTe which has sensitivity to light having a wavelength of 300 nm or less, and gallium nitride GaN which has sensitivity to light having a wavelength ranging from 200 nm to 370 nm. For such photoelectric conversion materials, the sensitivity to light having a wavelength of at least 400 nm or longer is zero, or negligibly small. When gallium nitride is used, the quantum efficiency (the number of photoelectrons emitted from the photoelectric surface 101 / the number of incident photons) thereof is advantageously high (21 .5% is obtained).

The photomultiplier 100 is connected to a power supply and a photon-counting circuit, which are not shown. The power supply is configured to supply a drive voltage to the photomultiplier 100. The photon-counting circuit may consist of an amplifier, a discriminator, and a multichannel analyzer (or counter), etc. The photon-counting circuit is configured for measuring the number of photons in the output of the photomultiplier 100 through a photon counting method. The photon-counting circuit is connected to an arithmetic device, which is not shown. The arithmetic device may consist of a CPU (Central Processing Unit) and a memory, etc. The arithmetic device is configured to normalize the number of photons outputted from the photon-counting circuit by the number of irradiated electrons (or current) with kinetic energy of the electron beam being continuously varied by the controller 34. This enables a spectrum (LEIPS spectrum) as a function of the kinetic energy of the electron beam. Alternatively, the number of non-normalized photons may be used as the LEIPS spectrum, which is obtained as a function of energy of the electron beam. The LEIPS spectrum corresponds to the density of states of an unoccupied state.

Further, the arithmetic device is configured to evaluate a difference between rising energy of the LEIPS spectrum and a vacuum level to determine the electron affinity of the sample 40, which is the minimum energy of an unoccupied state. The vacuum level may be determined through the following two well-known methods. In the first method, current flowing through the sample 40 (or board) is plotted as a function of energy of the electron beam. The vacuum level can be defined as the sum of the center transmission energy value of the bandpass filter 90 and the energy value at an inflection point in the rising portion of the plotted current. In the second method, photoelectron spectrum of the sample 40 is measured to determine cutoff energy of secondary electrons in the spectrum. The vacuum level can be defined as the sum of the cutoff energy value and an energy value of excitation light.

Referring now to Figs. 3(a) and 3(b), an advantage of the optical system according to an embodiment of the present invention will be described. In the conventional LEIPS shown in Fig. 3(a), the aforementioned focusing optics 80 only includes a lens 160. The lens 160 is disposed between the sample 40 and the bandpass filter 90. The diffused light emitted from the window 51 of the vacuum chamber 50 is focused to form an image on the photoelectric surface 101 of the photomultiplier 100. As such, a collimating lens is absent in the conventional optical system. Hereinafter, the lens 160 may be referred to as a converging lens. It should be noted that the present invention does not exclude an optical system in which a collimating lens is absent in the focusing optics 80.

In order to enhance a light capturing ability, the converging lens 160 is preferably disposed close to the sample 40 (distance P illustrated in the figure is reduced). On the other hand, when the aforementioned multilayer interference bandpass filter is used as the bandpass filter 90, the light system is preferably arranged so that light is incident on the bandpass filter 90 as vertically as possible (typically, an incident angle may be within 5° or less) with reference to the incident surface in order to obtain sufficiently high resolution. In this case, a distance (denoted by Q in the figure) between the converging lens 160 and the bandpass filter 90 is preferably larger. In order to satisfy these demands, magnification Q/P of the image formed on the photoelectric surface 101 of the photomultiplier 100 will be increased, so that a large photoelectric surface is required.

In a sample, in particular an organic semiconductor, the surface of the sample may be easily charged or the sample may be easily damaged when current density is increased. When the surface is charged, energy of the electron beam to be radiated is increased, so that the obtained LEIPS spectrum is shifted or deformed. To prevent the sample from becoming charged or damaged, the electron beam is preferably widened or extended to reduce its current density with an amount of irradiation electrons maintained. The widened electron beam enlarges the image formed on the photoelectric surface 101 as described above, and consequently a large photoelectric surface is required.

The photomultiplier 100 having a large photoelectric surface 101 in turn may increase a dark count and consequently background noise. Furthermore, the widened electron beam may decrease signal intensity.

On the other hand, the optical system according to an embodiment of the present invention shown in Fig. 3(b) has the following advantages; (1) the use of the collimating lens 60 allows light to enter or impinge on the incident surface of the band pass filter 90 at an angle near vertical incidence, so that high resolution is obtained; (2) the imaging lens 70 disposed between the bandpass filter 90 and the photomultiplier 100 allows magnification Q/P to be reduced, which consequently enables the photomultiplier 100 with a small photoelectric surface 101 to be used; (3) likewise, the imaging lens 70 disposed between the bandpass filter 90 and the photomultiplier 100 enables a signal intensity that is significantly increased in practical experimental conditions.

Discussed next is the advantage derived from the photoelectric conversion material of the solar-blind type used for the photoelectric surface 101 of the photomultiplier 100. In the conventional LEIPS, to detect weak light (near-ultraviolet light) emitted from the sample, bialkali (Sb-K-Cs alloy), which has high sensitivity to near-ultraviolet light, is used as a photoelectric conversion material. However, the bialkali also has high sensitivity to visible light. Accordingly, in order to reduce the background noise, it may be required to sufficiently shield the apparatus from the light. This leads to the increase of the cost for the apparatus. The background noise may be reduced by the use of the bandpass filter. It should be noted, however, that a bandpass filter with a center transmission wavelength of 254 nm, for example, reportedly has a transmissivity of 1% with respect to the light having a wavelength longer than 430 nm, which is in a visible light range. Further, if the shield is accidentally broken, a lifetime of a photomultiplier will be remarkably shortened, or in the worst case the photomultiplier may possibly break down.

Further, multilayer interference bandpass filters having a center transmission wavelength in an ultraviolet region often allow light within a visible light range to transmit therethrough. As a result, the use of these bandpass filters makes it difficult to observe light in an ultraviolet region.

Also, when yttrium oxide is used as the thermionic emission material like in an embodiment of the present invention, due to the fact that the temperature of yttrium oxide during operation is higher than that of barium oxide, light having a wavelength band is generated that is not generated when barium oxide is alternatively used. The light is subjected to photoelectric conversion by bialkali, and background noise may occur.

On the other hand, as exemplified in an embodiment of the present invention, the use of the photoelectric conversion material of the solar-blind type enables the following advantages. Since the photoelectric conversion material of the solar-blind type that is insusceptible to light having a wavelength of a visible light range; (1) the apparatus can be used with simple shielding; (2) a bandpass filter with a center transmission wavelength of an ultraviolet region can be used; and (3) background noise is not generated when yttrium oxide is used as a thermionic emission material.

Various modifications and improvement may be added to the aforementioned embodiments. The present invention is not limited to the embodiments. Modifications of the embodiments will be described.

In the embodiments, yttrium oxide is employed as the thermionic emission material of the cathode 10. If a solar-blind type photoelectric conversion material is used as the photoelectric surface 101 of the photomultiplier 100, similar advantages can be obtained when the other metals or oxides, etc. (e.g., barium oxide, lanthanum hexaboride LaB₆, tungsten W, tungsten rhenium alloy W-Re) are employed as the thermionic emission material. The cathode 10 is used as an example of the electron source. The cathode 10 may be an indirectly-heated cathode or a directly-heated cathode. The indirectly-heated cathode may include a cathode using barium oxide, lanthanum hexaboride, or yttrium oxide. The directly-heated cathode may include a cathode using tungsten W or tungsten rhenium alloy W-Re.

Further, in the embodiments, the bandpass filter 90 is used as the wavelength selector for extracting light having a certain wavelength (wavelength band) among the light generated in the sample 40, and the photomultiplier 100 is used as a photodetector for detecting the light extracted by the wavelength selector. A spectroscope and an exit slit referred to in Patent Document 1 and Non-Patent Document 3 may be used instead of the bandpass filter 90 to form the wavelength selector. Further, a spectroscope and a two-dimensional detector such as a CCD camera (or a one-dimensional detector such as a linear sensor) disclosed in Patent Document 1 and Non-Patent Document 4 may be used to form the wavelength selector and the photodetector. Furthermore, as the photodetector, an image intensifier configured to detect and multiply photoelectrons two-dimensionally may be used instead of the photomultiplier 100. There is an image intensifier available with a photoelectric surface of the solar-blind type. Alternatively, semiconductor photodetector that is cooled by liquid nitrogen may be used, for example.

Further, the illustrated photomultiplier 100 has a head-on type structure having a so-called transmission type photoelectric surface 101, but may be a structure having a so-called reflection type photoelectric surface, or the illustrated photomultiplier 100 may have a side-on type structure.

### [Example]

Hereinafter, the present invention will be described in detail using examples (Experiments 1 to 4), but the present invention is not limited to the examples.

In Experiments 1 to 4, a self-made Erdman-Zipf type electron gun was used as the electron gun 30. A diameter of the aperture 23 was set to be 0.50 mm, and a distance between the cathode 10 and the aperture 23 was set to be 1.0 mm. As described below, a disk of the yttrium oxide cathode (ES-525 made by Kimball Physics Inc.) has a diameter of 0.84 mm. Accordingly, the diameter of the aperture 23 is smaller than that of the disk. Further, current formed by the electron beam irradiated with the sample 40 was set to be 1.0 µA or less. As the sample 40, a thin film of silver provided on a board was used (Experiments 1 and 2). Specifically, ITO (indium tin oxide) with a thickness of 10 nm was deposited on a silica glass board by sputtering, and a thin film of silver with a thickness of 10 nm was vacuum-evaporated thereon. A turbo-molecular pump with 500 L/s displacement was used in the step of depressurizing the vacuum chamber 50.

### Experiment 1

A kinetic energy distribution of electrons emitted from the electron gun 30 was measured as a function of time. Accelerating voltage applied to the cathode 10 and bias voltage applied to the sample 40 were controlled to change kinetic energy of electrons. Two types of thermionic emission materials were used to compare measurement results. Experimental conditions were as follows:
(a) the cathode 10 was a barium oxide cathode (ES-015 made by Kimball Physics Inc.), and pressure in the vacuum chamber 50 was 3.0 x 10⁻⁹ Torr (4.0 x 10⁻⁹ hPa) (baking was performed at approximately 80°C for 12 hours), and
(b) the cathode 10 was an yttrium oxide cathode (ES-525 made by Kimball Physics Inc.), and the pressure in the vacuum chamber 50 was 1.5 x 10⁻⁸ Torr (2.0 x 10⁻⁸ hPa) (without baking).

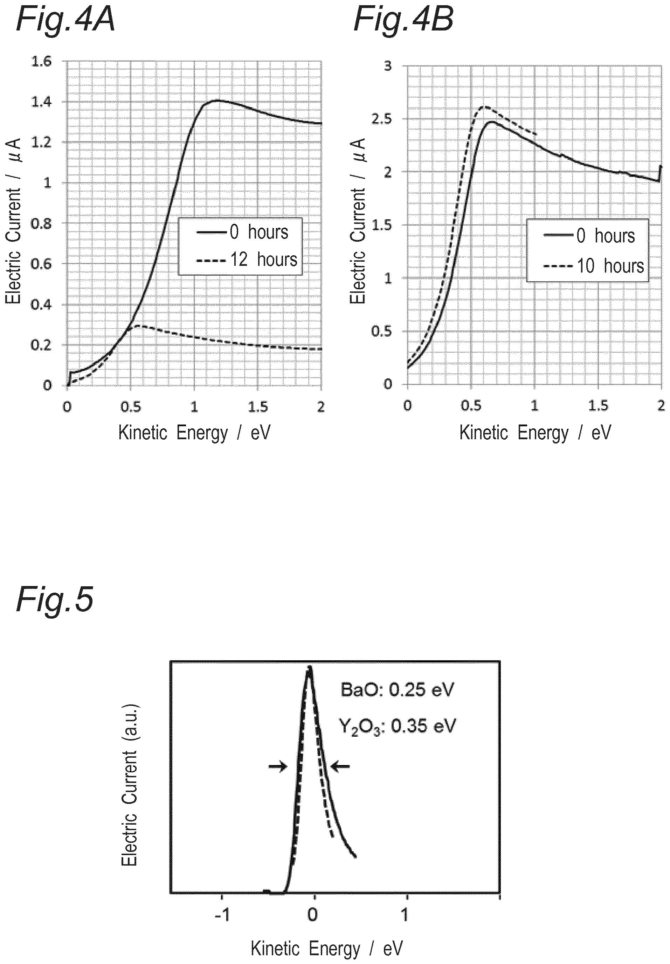

The results of Experiment 1 are shown in the graphs of Figs. 4(a) and 4(b). Horizontal axes of the graphs indicate kinetic energy of electrons (electron beam) calculated based upon the accelerating voltage and the bias voltage, while vertical axes indicate measured current values. Solid lines indicate measurement results at the time the experiment was started, while dashed lines indicate measurement results (a) after 12 hours and (b) after 10 hours from the start of the experiment. In the barium-oxide cathode (a), a current value significantly decreased after 12 hours from the start of the experiment. Further, a work function of the cathode 10 also decreased by 0.5 eV or more. Similar results were obtained even when the degree of vacuum was lower than 1 x 10⁻⁹ Torr (1 x 10⁻⁹ hPa). As such, the current value and the work function of the barium-oxide cathode 10 (a) were unstable due to long-term use, even when the cathode was in a high vacuum state and the baking was performed. On the other hand, there was little change in current value and the work function of the yttrium oxide cathode 10 (b). As such, the use of the yttrium oxide as a thermionic emission material ensures that the electron beam can be radiated stably for a long time, even if the thermionic emission material is not in an ultrahigh vacuum state with a pressure in the order of 10⁻⁹ Torr (10⁻⁹ hPa) and baking is not performed.

Fig. 5 is a graph showing a kinetic energy distribution of electrons emitted from the electron gun 30. In the barium oxide cathode (illustrated by dotted line), the emitted electrons had an energy width (half width of kinetic energy distribution) of 0.25 eV. In the yttrium oxide cathode (illustrated by solid line), the emitted electrons had an energy width of 0.35 eV. As described above, the energy width has substantially the same value as an energy width of electrons generated in the cathode 10. As described in the following Experiment 2, it has been confirmed from this result that the entire apparatus has a high resolution sufficient to be used as an inverse photoemission spectroscopy apparatus. It should be noted that Kimball Physics Inc. which is a manufacturer of the cathode used in this example reports that electrons generated in an yttrium oxide cathode have an energy width of 0.6 eV and the operation temperature thereof is 1800 K. As can be recognized by a person skilled in the art, the use of the cathode with such a large energy width makes it difficult for the apparatus in its entirety to obtain a high resolution sufficient to be used as an inverse photoemission spectroscopy apparatus, even when an existing material having a high resolution was used for the bandpass filter 90 etc. This may be why the yttrium oxide cathode has not been conventionally used. On the other hand, the result of Experiment 1 demonstrated that the sample 40 can be irradiated with the electron beam, with an energy width of electrons generated in the yttrium oxide cathode being reduced to be less than the above reported value (i.e., 0.6 eV).

### Experiment 2

Using the photomultiplier 100 of Fig. 1, a LEIPS spectrum of the sample 40 was measured under the same condition as Experiment 1 (b) in which the yttrium oxide cathode was used. Additional experimental conditions were as follows:
- the lens 60 was a quartz lens with a diameter of 50 mm and a focal distance of 100 mm;
- the lens 70 was a quartz lens with a diameter of 25 mm and a focal distance of 30 mm;
- the bandpass filter 90 had a center transmission wavelength of 254 nm and a half width of 0.23 eV (made by Semrock Inc. in USA); and
- the photomultiplier 100 had a Cs-Te photoelectric surface (R821 made by Hamamatsu Photonics Inc.).

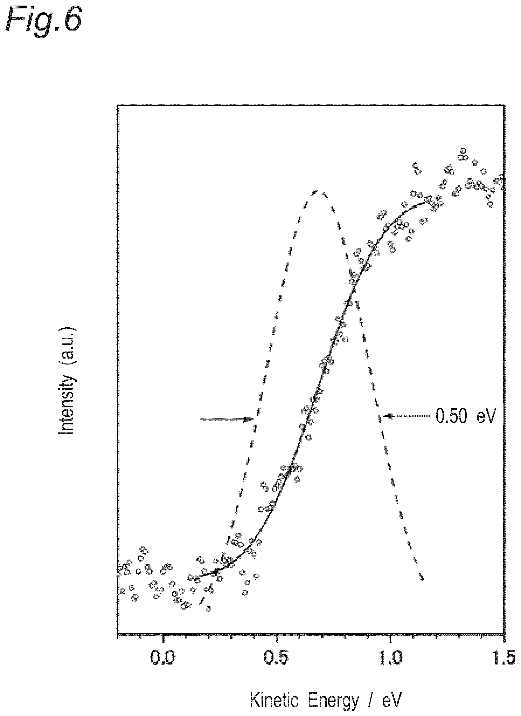

The result of Experiment 2 is shown in a graph of Fig. 6. A horizontal axis of the graph indicates kinetic energy of electrons, and a vertical axis indicates light intensity. Dots indicate LEIPS spectrums in the vicinity of Fermi edge, a solid line indicates a fitting line of the LEIPS spectrums based upon an error function, and a dotted line indicates the first derivative obtained from the LEIPS spectrums. In general, a Fermi edge of metal is spread according to Fermi distribution function which is spread with temperature. Based upon the spread of the Fermi edge in the sample 40, the inverse photoemission spectroscopy apparatus 1 in its entirety can be assumed to have a resolution of 0.50 eV. The resolution of 0.50 eV is sufficient to be used as an inverse photoemission spectroscopy apparatus. The resolution of the entire apparatus can be generally approximated by (ΔE² + ΔhV²)^{½}, where ΔE is an energy width of the electron beam, and Δhv is a resolution of a combination of the bandpass filter 90 and the photomultiplier 100. The improvement of the resolution of the bandpass filter 90 and the photomultiplier 100 can further improve the resolution of the apparatus 1 in its entirety. As such, the use of the yttrium oxide as the thermionic emission material demonstrated that the inverse photoemission spectroscopy apparatus 1 can obtain a high resolution without the step of depressurizing the vacuum chamber 50 to an ultrahigh-vacuum state and without baking.

### Experiment 3

Using the inverse photoemission spectroscopy apparatus 1 of Fig. 1, a LEIPS spectrum of the sample 40 was measured under the same condition as Experiment 1(b) in which the yttrium oxide cathode was used. In the photomultiplier 100, a Cs-Te photoelectric surface (R821 made by Hamamatsu Photonics Inc.) and a bialkali photoelectric surface (R585s made by Hamamatsu Photonics Inc.) were used to compare measurement results therebetween. As the sample 40, zinc phthalocyanine (ZnPC) which is an organic semiconductor was used.

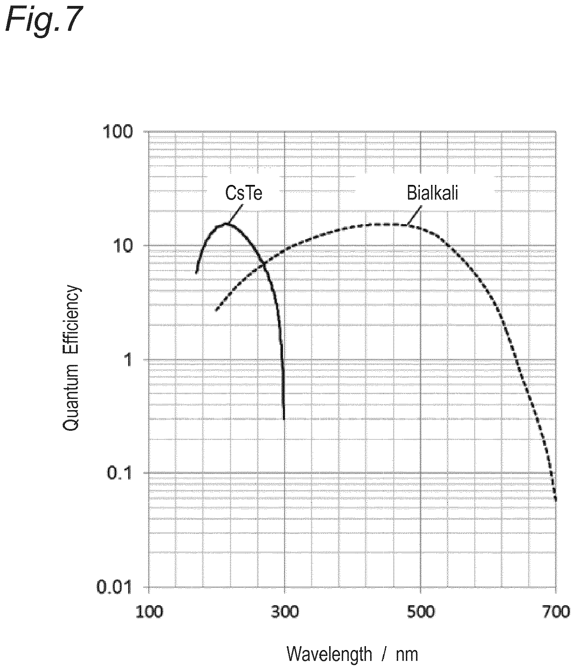

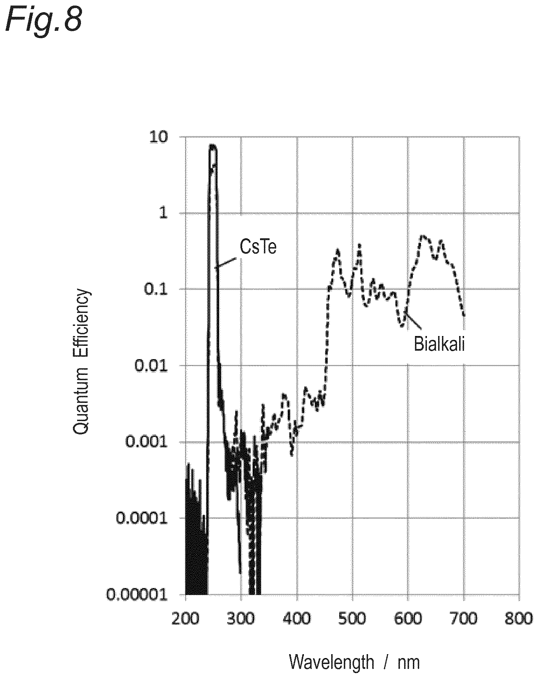

Fig. 7 is a graph showing quantum efficiency as a function of wavelength for a photomultiplier with a Cs-Te photoelectric surface (R821 made by Hamamatsu Photonics Inc.) and a photomultiplier with a bialkali photoelectric surface (R585s made by Hamamatsu Photonics Inc.). Fig. 8 is a graph showing quantum efficiency as a function of wavelength for a combination of these photomultipliers and the bandpass filter. In each of the graphs, a horizontal axis indicates a wavelength and a vertical axis indicates quantum efficiency. Solid lines indicate measurement results for the Cs-Te photoelectric surface, and dotted lines indicate measurement results for the bialkali photoelectric surface.

It can be seen that the bialkali photoelectric surface has sensitivity to light having a wavelength ranging from 200 nm to 700 nm, while the Cs-Te photoelectric surface is substantially insusceptible to light having a wavelength longer than 300 nm.

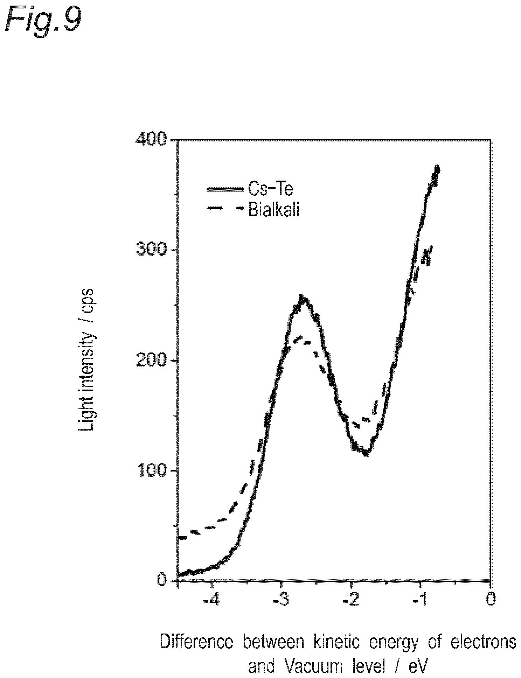

The result of Experiment 3 is shown in the graph of Fig. 9. A horizontal axis of the graph indicates a difference between kinetic energy of electrons and a vacuum level, and a vertical axis indicates light intensity. It can be seen that, in the Cs-Te photoelectric surface, a background noise observed at -4 eV or less is weak. This confirms that when the light having a wavelength band ranging from 200 nm to 300 nm is measured by the use of the Cs-Te photoelectric surface, background noise will be reduced as compared with the bialkali photoelectric surface.

### Experiment 4

Using the inverse photoemission spectroscopy apparatus 1 of Fig. 1, a LEIPS spectrum of the sample 40 (a thin film of silver) in the vicinity of Fermi edge was measured under the same condition as Experiment 1(a) in which the barium-oxide cathode was used. As shown in Figs. 3(a) and (b), two types of the optical systems were used to compare measurement results therebetween.

Additional experimental conditions were as follows:
- the lens 60 (160) was a quartz lens with a diameter of 25 mm and a focal distance of 25 mm;
- the lens 70 was a quartz lens with a diameter of 25 mm and a focal distance of 30 mm; and
- the photomultiplier 100 had a bialkali photoelectric surface (R585s made by Hamamatsu Photonics Inc.).

The lenses 60 (160) and 70 were disposed so that a magnification Q/P= 12 was satisfied in the optical system of Fig. 3(a) and a magnification Q/P= 1.2 was satisfied in the optical system of Fig. 3(b). The photoelectric surface 101 of the photomultiplier 100 had a size of 5 mm x 8 mm. An irradiation area, when the sample 40 was irradiated with the electron beam, was set to have a radius ranging from 1 mm to 2 mm.

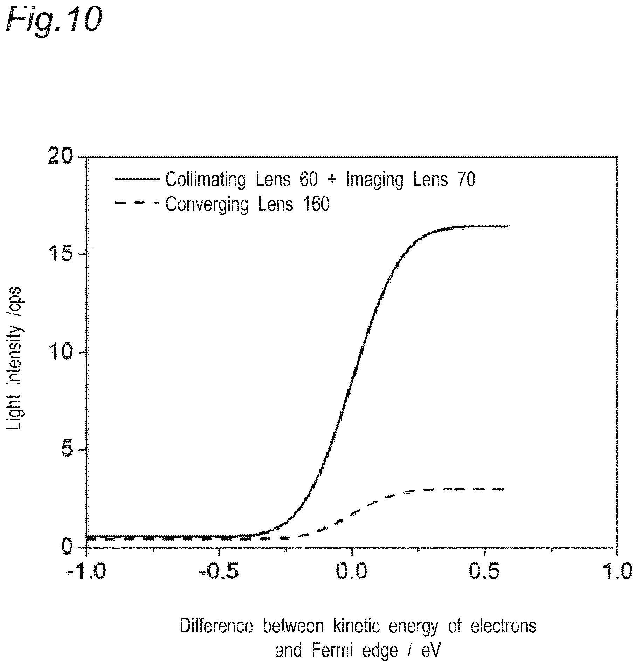

The result of Experiment 4 is shown in the graph of Fig. 10. A horizontal axis of the graph indicates a difference between kinetic energy of electrons and a Fermi edge, while a vertical axis indicates light intensity. Further, a solid line indicates the measurement result when the collimating lens 60 and the imaging lens 70 were provided as the focusing optics 80 (the optical system according to an embodiment of the present invention), and a dotted line indicates a measurement result when only the converging lens 160 was provided as the focusing optics 80 (optical system according to the conventional LEIPS). It can be seen from Fig. 10 that the signal intensity (or light intensity) of the optical system according to an embodiment of the present invention shown by the solid line is increased by approximately one order of magnitude as compared with the optical system according to the conventional LEIPS shown by the dotted line. On the other hand, as for the resolution of the LEIPS spectrum evaluated from a spread of Fermi edge, there was no difference between both optical systems.

In the aforementioned examples, a Stoffel-Johnson type electron gun can be alternatively used instead of the Erdman-Zipf type electron gun. Both types of electron guns will have similar results. Further, a bandpass filter 90 made by Asahi spectrum Inc. can be used, which has results similar to aforementioned results.

According to the present invention, an inverse photoemission spectroscopy apparatus which is easy to handle is available at low cost. Accordingly, the present invention may be suitably used in the field of organic electronics. In particular, the present invention enables an accurate and easy measurement of a valence level and an unoccupied state energy. This promotes development of devices using an organic semiconductor, such as an organic thin film transistor and an organic thin film solar cell.

### DESCRIPTION OF REFERENCE SYMBOLS

- 1: INVERSE PHOTOEMISSION SPECTROSCOPY APPARATUS
- 10: CATHODE (ELECTRON SOURCE)
- 20: ELECTRON LENS
- 21: ELECTRODE
- 30: ELECTRON GUN
- 40: SAMPLE
- 50: VACUUM CHAMBER
- 60: COLLIMATING LENS
- 70: IMAGING LENS
- 80: FOCUSING OPTICS
- 90: BANDPASS FILTER (WAVELENGTH SELECTOR)
- 100: PHOTOMULTIPLIER (PHOTODETECTOR)
- 101: PHOTOELECTRIC SURFACE (PHOTOELECTRIC CONVERTER)
- 102: DYNODE (ELECTRON MULTIPLYER)

## Claims

1. An inverse photoemission spectroscopy apparatus (1) for detecting a light generated by the relaxation of electrons to an unoccupied state of a sample (40), the apparatus (1) comprising:
an electron source (10) for generating electrons with which a sample (40) is irradiated;
a wavelength selector (90) for extracting a light having a certain wavelength from the light generated in the sample (40);
a photodetector (100) for detecting the light extracted by the wavelength selector (90); and
a focusing optics (80) disposed between the sample (40) and the photodetector (100), wherein the electron source (10) contains yttrium oxide as a thermionic emission material,
wherein the photodetector (100) includes a photoelectric converter (101) that is insusceptible or insensitive to a light having a wavelength of 400 nm or longer.

2. The inverse photoemission spectroscopy apparatus (1) of claim 1, wherein the photoelectric converter (101) contains a photoelectric conversion material selected from the group consisting of cesium iodide, cesium tellurium, and gallium nitride.

3. The inverse photoemission spectroscopy apparatus (1) of claim 1 or 2, wherein the focusing optics (80) includes:
a collimating lens (60) disposed between the sample (40) and the wavelength selector (90) so that the light generated in the sample (40) is shaped into a collimated light flux; and
an imaging lens (70) disposed between the wavelength selector (90) and the photodetector (100) so that the light extracted by the wavelength selector (90) is focused to form an image on the photoelectric converter (101) of the photodetector (100).

4. The inverse photoemission spectroscopy apparatus (1) of any one of claims 1-3, wherein the wavelength selector (90) is an interference bandpass filter (90) of a dielectric multilayer.

5. The inverse photoemission spectroscopy apparatus (1) of any one of claims 1-4, wherein the sample (40) is irradiated with an electron beam having electron kinetic energy of 5 eV or less, and the wavelength selector (90) includes a bandpass filter having a center transmission wavelength in an ultraviolet region.

## Patentansprüche

1. Vorrichtung (1) zur inversen Photoemissionsspektroskopie zur Erfassung eines durch die Relaxation von Elektronen in einen unbesetzten Zustand einer Probe (40) erzeugten Lichts, wobei die Vorrichtung (1) Folgendes umfasst:
eine Elektronenquelle (10) zur Erzeugung von Elektronen, mit denen eine Probe (40) bestrahlt wird,
einen Wellenlängenselektor (90) zum Extrahieren eines Lichts mit einer bestimmten Wellenlänge aus dem in der Probe (40) erzeugten Licht,
einen Photodetektor (100) zur Erfassung des vom Wellenlängenselektor (90) extrahierten Lichts und
eine Fokussieroptik (80), die zwischen der Probe (40) und dem Photodetektor (100) angeordnet ist, wobei die Elektronenquelle (10) Yttriumoxid als Glühemissionsmaterial enthält,
wobei der Photodetektor (100) einen photoelektrischen Wandler (101) aufweist, der gegenüber einem Licht mit einer Wellenlänge von 400 nm oder länger unempfänglich oder unempfindlich ist.

2. Vorrichtung (1) zur inversen Photoemissionsspektroskopie nach Anspruch 1, wobei der photoelektrische Wandler (101) ein photoelektrisches Umwandlungsmaterial enthält, das aus der aus Cäsiumjodid, Cäsiumtellur und Galliumnitrid bestehenden Gruppe ausgewählt ist.

3. Vorrichtung (1) zur inversen Photoemissionsspektroskopie nach Anspruch 1 oder 2, wobei die Fokussieroptik (80) Folgendes aufweist:
eine Kollimatorlinse (60), die so zwischen der Probe (40) und dem Wellenlängenselektor (90) angeordnet ist, dass das in der Probe (40) erzeugte Licht zu einem kollimierten Lichtfluss geformt wird, und
eine Abbildungslinse (70), die so zwischen dem Wellenlängenselektor (90) und dem Photodetektor (100) angeordnet ist, dass das vom Wellenlängenselektor (90) extrahierte Licht so gebündelt wird, dass es auf dem photoelektrischen Wandler (101) des Photodetektors (100) ein Bild bildet.

4. Vorrichtung (1) zur inversen Photoemissionsspektroskopie nach einem der Ansprüche 1-3, wobei der Wellenlängenselektor (90) ein Interferenzbandpassfilter (90) einer dielektrischen Mehrfachschicht ist.

5. Vorrichtung (1) zur inversen Photoemissionsspektroskopie nach einem der Ansprüche 1-4, wobei die Probe (40) mit einem Elektronenstrahl mit einer kinetischen Elektronenenergie von 5 eV oder weniger bestrahlt wird und der Wellenlängenselektor (90) ein Bandpassfilter mit einer mittleren Übertragungswellenlänge in einem ultravioletten Bereich aufweist.

## Revendications

1. Dispositif de spectroscopie de photoémission inverse (1) pour détecter une lumière générée par la relaxation d'électrons dans un état inoccupé d'un échantillon (40), le dispositif (1) comprenant :
une source d'électrons (10) pour générer des électrons avec lesquels un échantillon (40) est irradié ;
un sélecteur de longueur d'onde (90) pour extraire une lumière à longueur d'onde spécifique à partir de la lumière générée dans l'échantillon (40) ;
un photodétecteur (100) pour détecter la lumière extraite par le sélecteur de longueur d'onde (90) ; et
une optique de focalisation (80) agencée entre l'échantillon (40) et le photodétecteur (100), la source d'électrons (10) contenant de l'oxyde d'yttrium en tant que matériau d'émission thermoionique,
le photodétecteur (100) présentant un convertisseur photoélectrique (101) qui est non susceptible ou insensible à une lumière à une longueur d'onde égale ou supérieure à 400 nm.

2. Dispositif de spectroscopie de photoémission inverse (1) selon la revendication 1, dans lequel le convertisseur photoélectrique (101) contient un matériau de conversion photoélectrique choisi dans le groupe constitué de iodure de césium, de tellure de césium et de nitrure de gallium.

3. Dispositif de spectroscopie de photoémission inverse (1) selon la revendication 1 ou 2, dans lequel l'optique de focalisation (80) comporte :
une lentille de collimation (60) agencée entre l'échantillon (40) et le sélecteur de longueur d'onde (90) de sorte que la lumière générée dans l'échantillon (40) est formée en un flux de lumière collimatée ; et
une lentille d'imagerie (70) agencée entre le sélecteur de longueur d'onde (90) et le photodétecteur (100) de sorte que la lumière extraite par le sélecteur de longueur d'onde (90) et focalisée de manière à former une image sur le convertisseur photoélectrique (101) du photodétecteur (100).

4. Dispositif de spectroscopie de photoémission inverse (1) selon l'une des revendications 1 à 3, dans lequel le sélecteur de longueur d'onde (90) est un filtre passe-bande antiparasite (90) d'une couche multiple diélectrique.

5. Dispositif de spectroscopie de photoémission inverse (1) selon l'une des revendications 1 à 4, dans lequel l'échantillon (40) est irradié avec un faisceau d'électrons présentant une énergie cinétique d'électron égale ou inférieure à 5 eV, et dans lequel le sélecteur de longueur d'onde (90) présente un filtre passe-bande à une longueur d'onde de transmission centrale dans une région des ultraviolets.
